# EUROPÄISCHE PATENTSCHRIFT

(11) **EP 0 896 503 B1**
(45) Veröffentlichungstag und Bekanntmachung des Hinweises auf die Patenterteilung: **20.04.2005**
(21) Anmeldenummer: 98114504.8
(22) Anmeldetag: 01.08.1998
(51) Int. Cl.: H05K 5/02, H05K 9/00, B29C 45/14

(54) **Kunststoffgehäuse mit einem Metalleinlegeteil in einem Montageflansch**
Plastic housing with metallic insert in montage flange
Boîtier plastique dont la patte de montage est pourvue d'un insert métallique

(30) Priorität: 07.08.1997 DE 19734128
(43) Veröffentlichungstag der Anmeldung: 10.02.1999
(73) Patentinhaber: Conti Temic microelectronic GmbH, 90411 Nürnberg (DE)
(72) Erfinder: Baur, Richard, 85276 Pfaffenhofen (DE); Fendt, Günter, 86529 Schrobenhausen (DE); Wörle, Engelbert, 86556 Kühbach (DE)

(56) Entgegenhaltungen:
- DE-A- 3 916 899
- DE-A- 4 131 779
- GB-A- 2 216 166

## Beschreibung

Die Erfindung betrifft ein Kunststoffgehäuse zur Aufnahme einer elektrischen Leiterplatte gemäß dem Oberbegriff des Patentanspruchs 1.

Elektronische Baugruppen werden insbesondere in der Automobilindustrie zunehmend mit Kunststoffgehäusen ausgeführt, da diese neben der relativ einfachen und kostengünstigen Herstellung insbesondere erheblich leichter sind, wodurch wiederum der Spritverbrauch sinkt. Zur Befestigung der Kunststoffgehäuse an einem metallischen Trägerkörper weist das Kunststoffgehäuse im allgemeinen einen Montageflansch mit einer Öffnung auf. Da jedoch der Montageflansch des Kunststoffgehäuses an der Öffnung durch Montagekräfte, beispielsweise beim Verschrauben oder Vernieten, recht leicht verformt oder beschädigt werden kann, wird ein Metalleinlegeteil zur Erhöhung der übertragbaren Kräfte eingesetzt, wie es beispielsweise der DE 39 16 899 A1 entnommen werden kann. Aus der DE 41 31 779 A1ist darüber hinaus eine Schraubbefestigung zu entnehmen, bei der in einer Gehäuseabdeckung eine Buchse für eine Halsschraube angeordnet ist.

Nachteil der Metallanlegeteile ist jedoch, daß es am Übergang zwischen Metalleinlegeteil und metallischem Trägerkörper zur Ausbildung eines chemischen Kontaktübergangs kommen kann, wenn Trägerkörper und Metalleinlegeteil aus unterschiedlichen Metallen bzw. Metallegierungen bestehen. Durch Feuchtigkeitseinflüsse und Elektrolyte bildet sich zwischen diesen eine der elektrochemischen Spannungsreihe entsprechende Spannung aus, was zu Störungen elektrischer Komponenten im Inneren des Kunststoffgehäuses führen kann oder langfristig die Übergangsstelle zerstört. Aus dem Merkblatt 1.031 der Arbeitsgemeinschaft Korrosion ist für diesen Fall die Verwendung von Kunststoffscheiben und Isolierbinden bereits bekannt, wie sie beispielsweise aus dem Gebrauchsmuster G 93 03 091 U1 entnommen werden kann. Solche zusätzlichen Kunststoffteile erfordern jedoch zusätzliche Bestückungs-, Justier- und Montageschritte, so daß der Montageaufwand erheblich steigt.

Aufgabe der Erfindung ist daher ein Kunststoffgehäuse vorzustellen, welches auf besonders einfache Weise die oben genannten Nachteile vermeidet.

Die Aufgabe ist durch die kennzeichnenden Merkmale des Patentanspruchs 1 gelöst. Am Montageflansch des Kunststoffgehäuses wird an der Montageseite ein Kunststoffüberstand vorgesehen, welche das Metalleinlegeteil vom Trägerkörper isoliert. Gemäß Patentanspruch 2 ist der Kunststoffüberstand mit einer Öffnung zentriert zu der Öffnung im Metalleinlegeteil versehen. Der Durchmesser der Öffnung im Kunststoffüberstand ist gleich oder größer als der Durchmesser der Öffnung im Metalleinlegeteil, wodurch das Verbindungselement zur Montage des Montageflansches an den Trägerkörper durch den Kunststoffüberstand hinweg geführt werden kann. Vorteil ist dabei gemäß Patentanspruch 3, daß der Durchmesser der Öffnungen im Kunststoffüberstand kleiner als der Außendurchmesser des Metalleinlegeteil im Montageflansch ist, da dadurch neben der Isolation auch noch eine Haltefunktion des Kunststoff überstand für das Metalleinlegeteil entsteht. Dadurch kann die Anordnung leichter montiert und gegebenenfalls auf eine Einpressung des Metalleinlegeteils in den Montageflansch verzichtet werden.

In der bevorzugten Weiterbildung der Erfindung gemäß Patentanspruch 4 ist die Dicke des Kunststoffüberstandes zum Trägerkörper hin zwischen 0,1 und 0,5 mm. Eine derart dünne Ausgestaltung des Kunststoffüberstandes führt zu einer recht geringen Verformung dessen während des Verbindungsmittels des Verbindungselements und stellt quasi eine Dichtung dar.

Die Erfindung soll im folgenden anhand von Ausführungsbeispielen und Figuren näher erläutert werden:
- Figur 1: Schnitt durch einen Montageflansch mit einem abstehenden Kunststoffüberstand,
- Figur 2: Montageflansch mit einem in die Oberfläche abgesenkten Kunststoffüberstand gegenüber dem Metalleinlegeteil.

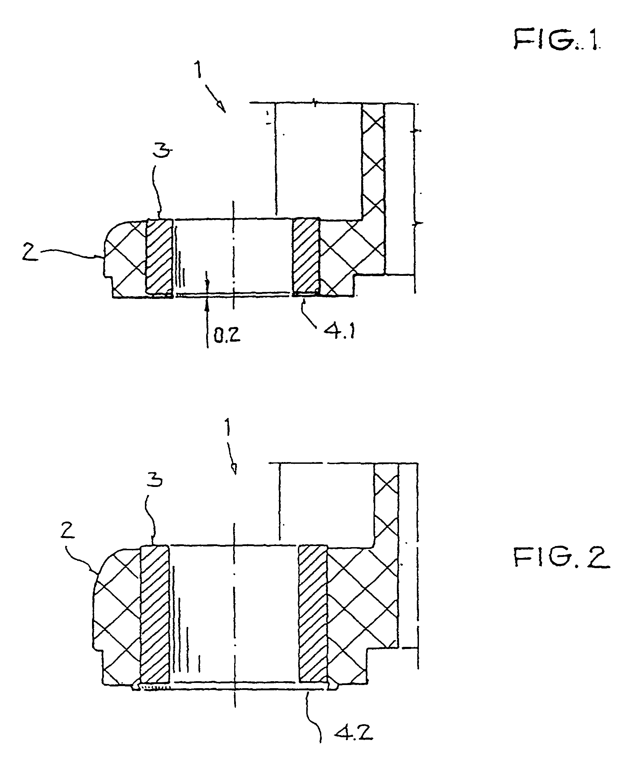

In Figur 1 ist ein Kunststoffgehäuse 1 ansatzweise gezeigt, an welchem sich ein Montageflansch befindet. Selbstverständlich kann ein Kunststoffgehäuse grundsätzlich mehrere derartige Montageflansche aufweisen, die alle analog mit einem Kunststoffüberstand versehen werden. Im Montageflansch 2 befindet sich das metallische Einlegeteil 3, dieses ist gegenüber dem Trägerkörper 5 durch den Kunststoffüberstand 4.1 isoliert und vor Feuchtigkeitseinflüssen weitgehend schützt. Der Kunststoffüberstand bildet dabei mit dem Montageflansch eine planare Fläche in Richtung des Trägerkörpers. Der Kunststoffüberstand wirkt dabei quasi wie ein dünnes Dichtungshäutchen, welches in diesem Ausführungsbeispiel 0,2 mm dick gewählt wurde. Der Kunststoffüberstand weist dabei eine Öffnung für das Verbindungselement auf, welches bspw. eine Schraube oder ein Niet sein kann. Der Durchmesser der Öffnungen im Kunststoffüberstand ist aber kleiner als der Außendurchmesser des Metalleinlegeteils im Montageflansch.

Figur 2 zeigt ebenfalls ein Kunststoffgehäuse 1 mit einem Montageflansch 2, in dem sich ein Metalleinlegeteil 3 befindet. In diesem Ausführungsbeispiel ist der Kunststoffüberstand 4.2 als Isolationsschicht auf die Montageseite des Kunststoffflansches sowie des Metalleinlegeteiles aufgesetzt. Der Kunststoffüberstand 4.2 ist dabei zentriert zur Öffnung im Metalleinlegeteil 3 ausgerichtet und weist eine gleichmäßige Dicke auf.

## Patentansprüche

1. Kunststoffgehäuse (1) mit einem eine Öffnung aufweisenden Metalleinlegeteil (3) in einem Montageflansch (2) mit einer Montageseite, welches mittels eines Verbindungselements mit der Montageseite an einem metallischen Trägerkörper befestigt ist, **dadurch gekennzeichnet, daß**
das Kunststoffgehäuse (1) am Montageflansch (2) an der Montageseite einen Kunststoffüberstand (4.1,4.2) aufweist, welcher so zwischen dem Metalleinlegeteil (3) und dem metallischen Trägerkörper angeordnet ist, daß er das Metalleinlegeteil (3) vom Trägerkörper isoliert und vor Feuchtigkeitseinflüssen schützt.

2. Kunststoffgehäuse nach Anspruch 1, **dadurch gekennzeichnet, daß** der Kunststoffüberstand (4.1,4.2) eine Öffnung zentriert zu der Öffnung im Metalleinlegeteil (3) aufweist und der Durchmesser der Öffnung im Kunststoffüberstand (4.1,4.2) gleich bzw. größer als der Durchmesser der Öffnung im Metalleinlegeteil (3) ist.

3. Kunststoffgehäuse nach Anspruch 1 oder 2, **dadurch gekennzeichnet, daß** der Durchmesser der Öffnung im Kunststoffüberstand (4.1) kleiner als der Außendurchmesser des Metalleinlegeteils (3) im Montageflansch (2) ist.

4. Kunststoffgehäuse nach einem der vorangehenden Ansprüche, **dadurch gekennzeichnet, daß** die Dicke des Kunststoffüberstandes zum Trägerkörper hin zwischen 0,1 und 0,5 mm ist.

## Claims

1. Plastics housing (1) with a metal insert (3), which comprises an opening, in a mounting flange (2) with a mounting side, which housing is fastened by way of the mounting side to a metallic carrier body by means of a connecting element, **characterised in that**
the plastics housing (1) comprises on the mounting side at the mounting flange (2) a plastics projection (4.1, 4.2) which is disposed between the metal insert (3) and the metallic carrier body such that it insulates the metal insert (3) from the carrier body and protects it against moisture effects.

2. Plastics housing according to Claim 1, **characterised in that** the plastics projection (4.1, 4.2) comprises an opening which is centred relative to the opening in the metal insert (3), and the diameter of the opening in the plastics projection (4.1, 4.2) is the same as or greater than the diameter of the opening in the metal insert (3).

3. Plastics housing according to Claim 1 or 2, **characterised in that** the diameter of the opening in the plastics projection (4.1) is smaller than the outside diameter of the metal insert (3) in the mounting flange (2).

4. Plastics housing according to any one of the preceding Claims, **characterised in that** the thickness of the plastics projection towards the carrier body is between 0.1 and 0.5 mm.

## Revendications

1. Boîtier en matière plastique (1) comprenant un insert métallique (3) muni d'une ouverture et prévu dans une bride de montage (2) avec un côté montage, qui est susceptible d'être fixé par le côté montage sur un corps porteur métallique au moyen d'un élément de liaison, **caractérisé en ce que** le boîtier en matière plastique (1) comprend sur la bride de montage (2) du côté montage une partie en matière plastique en porte-à-faux (4.1, 4.2) qui est agencée entre l'insert métallique (3) et le corps porteur métallique de manière à isoler l'insert métallique (3) vis-à-vis du corps porteur et à le protéger contre les influences de l'humidité.

2. Boîtier en matière plastique selon la revendication 1, **caractérisé en ce que** la partie plastique en porte-à-faux (4.1, 4.2) présente une ouverture centrée par rapport à l'ouverture dans l'insert métallique (3) et **en ce que** le diamètre de l'ouverture dans la partie plastique en porte-à-faux (4.1, 4.2) est égal ou supérieur au diamètre de l'ouverture dans l'insert métallique (3).

3. Boîtier en matière plastique selon l'une ou l'autre des revendications 1 et 2, **caractérisé en ce que** le diamètre de l'ouverture dans la partie plastique en porte-à-faux (4.1) est inférieur au diamètre extérieur de l'insert métallique (3) dans la bride de montage (2).

4. Boîtier en matière plastique selon l'une des revendications précédentes, **caractérisé en ce que** l'épaisseur de la partie plastique en porte-à-faux vers le corps porteur est comprise entre 0,1 et 0,5 mm.
